Europäisches Patentamt

European Patent Office

Office européen des brevets

(19)

(11) Publication number: 0 534 329 A2

# EUROPEAN PATENT APPLICATION

(12)

(21) Application number: 92116041.2

(22) Date of filing: 18.09.92

(51) Int. Cl.5: H01L 27/092, H01L 29/76

(30) Priority: 24.09.91 JP 243139/91

(43) Date of publication of application:
31.03.93 Bulletin 93/13

(84) Designated Contracting States:
DE FR

(71) Applicant: SMALL POWER COMMUNICATION
SYSTEMS RESEARCH LABORATORIES CO.,
LTD.
Mubanchi, Kawauchi, Aoba-ku
Sendai-shi, Miyagi-ken(JP)

(72) Inventor: Nishizawa, Jun-ichi, c/o Small Power
Com. Systems
Research Lab. Co. Ltd., Mubanchi, Kawauchi
Aoba-ku, Sendai-shi, Miyagi-ken(JP)
Inventor: Takeda, Nobuo, c/o Small Power
Com. Systems
Research Lab. Co. Ltd., Mubanchi, Kawauchi
Aoba-ku, Sendai-shi, Miyagi-ken(JP)
Inventor: Kishine, Toshiyuki, c/o Small Power
Com. Systems
Research Lab. Co. Ltd., Mubanchi, Kawauchi
Aoba-ku, Sendai-shi, Miyagi-ken(JP)

(74) Representative: Sajda, Wolf E., Dipl.-Phys. et
al
MEISSNER, BOLTE & PARTNER
Widenmayerstrasse 48 Postfach 86 06 24
W-8000 München 86 (DE)

(54) Notched insulation gate static induction transistor integrated circuit.

(57) A notched insulation gate static induction transistor integrated circuit according to the present invention comprises an enhancement mode CMOS logic circuit (a, b) including a notched insulation gate static induction transistor in which a threshold voltage is determined to prevent current from flowing in a standby mode, and a depletion enhancement mode CMOS logic circuit (c, d) including a notched insulation gate static induction transistor in which a threshold voltage is determined to cause current to slightly flow in the standby mode. The enhancement mode CMOS logic circuit (a, b) and the depletion enhancement mode CMOS logic circuit (c, d) are formed on a major surface of a substrate (10), and the depletion enhancement mode CMOS logic circuit (c, d) is used in a circuit in which an average power consumption in a switching operation is higher than that in the standby mode.

FIG. 1

a: n-ch INSULATED GATE SIT WITH p-TYPE POLY-SILICON ELECTRODE
b: p-ch INSULATED GATE SIT WITH n-TYPE POLY-Si ELECTRODE
c: n-ch INSULATED GATE SIT WITH n-TYPE POLY-Si ELECTRODE
d: p-ch INSULATED GATE SIT WITH p-TYPE POLY-Si ELECTRODE

E MODE CMOS LOGIC CIRCUIT

DE MODE CMOS LOGIC CIRCUIT

The present invention relates to an integrated circuit capable of high-speed and low-power operation and, more particularly, to a CMOS integrated circuit using U-grooved insulated gate static induction transistors achievable of a high-speed and low-power operation even when a supplied voltage is small.

A CMOS integrated circuit using conventional MOS transistors is generally used in a random logic, a memory, or the like and its greatest feature is low-power operation. In this conventional CMOS integrated circuit, stored charges in a load capacitor C correspond to energy loss within a transient state ($0 \rightarrow 1$, $1 \rightarrow 0$ or $H \rightarrow L$, $L \rightarrow H$). Power dissipation P can thus be expressed by the following equation.

$$P = C \times V^2 \times f \quad \text{(V: Power supply voltage, f:}$$
Operation frequency) (1)

Since no current flows or no energy is dissipated in a steady state of the conventional CMOS integrated circuit, the circuit is characterized by low-power operation in view of its principle.

However, a conventional MOS transistor used for CMOS integrated circuit is so designed as to use the vicinity of an interface between a semiconductor and an oxide film to move carriers. Therefore, the conventional MOS transistor has the drawback of poor drivability and low-speed operation.

The inventors of the present invention proposed a U-grooved insulated gate static induction transistor in, for example, Japanese Patent Application No. 52-1370, which eliminates the above drawback and has excellent characteristics as a high-speed switching device or a high-speed, low-power integrated circuits. Since this U-grooved insulated gate static induction transistor is so designed that the drain field effect reaches to the source, current flows in the substrate as well as in the interface between the semiconductor and insulation film. Therefore, the transistor has unsaturated current-voltage characteristics and high drivability. The transistor also has the advantage of decreasing a stray capacitance in view of its principle.

According to J. Nishizawa et al., "IEEE Transactions on Electron Devices," Vol. ED-37, No. 8, pp. 1877-1883 (1990), if a CMOS integrated circuit is formed using a U-grooved insulated gate static induction transistor on condition that a design rule is 1 $\mu$m and the depth of a U-shaped groove is 0.5 $\mu$m, the minimum switching time of 49 psec is obtained at a power dissipation of 7 mW.

In the CMOS integrated circuit of the U-grooved insulated gate static induction transistor, the power dissipation is determined by the same way as in the conventional CMOS integrated circuit, $C \times V^2 \times f$, it is effective in low-power operation to decrease the supplied voltage.

However, the decrease in the supplied voltage also reduces the drivability of the U-grooved insulated gate static induction transistor and prevents a high-speed operation thereof. So, high speed operation is incompatible with low voltage operation even if the U-grooved insulated gate static induction transistor is used.

It is accordingly an object of the present invention to provide a CMOS integrated circuit using U-grooved insulated gate static induction transistors capable of low-power and high-speed operation at a low supplied voltage.

A CMOS integrated circuit according to the present invention comprises an enhancement mode CMOS logic circuit including a U-grooved insulated gate static induction transistor in which a threshold voltage is determined to prevent current from flowing in a steady state, and a depletion enhancement mode CMOS logic circuit including a U-grooved insulated gate static induction transistor in which a threshold voltage is determined to cause current to slightly flow in the steady state. The enhancement mode CMOS logic circuit and said depletion enhancement mode CMOS logic circuit are formed on a major surface of a substrate, and the depletion enhancement mode CMOS logic circuit is used in a circuit in which an average power dissipation in a transient state is higher than that in the steady state.

This invention can be more fully understood from the following detailed description when taken in conjunction with the accompanying drawings, in which:

Fig. 1 is a cross-sectional view showing a constitution of CMOS integrated circuit using U-grooved a insulated gate static induction transistor according to an embodiment of the present invention;

Fig. 2 is a graph showing a gate voltage - drain current characteristic of the U-grooved insulated gate static induction transistor in Fig. 1;

Fig. 3 is a graph showing a relationship between supplied voltage and energy loss in which a depletion enhancement mode CMOS logic circuit and an enhancement mode CMOS logic circuit are compared;

Fig. 4 is a graph showing a relationship between supplied voltage and the maximum operation frequency in which depletion enhancement mode CMOS logic circuit and the enhancement mode CMOS logic circuit are compared;

Fig. 5 is a graph showing a relationship between the operation frequency and power dissipation at the supplied voltage of 1.5V in which the depletion enhancement mode CMOS logic circuit and the enhancement mode CMOS logic circuit are compared;

Fig. 6 is a circuit diagram of an eight-stage (1/256) frequency divider using a trigger flip-flop circuit; and

Fig. 7 is a view of mask patterns of polysilicon electrodes on the fourth and fifth stages of the eight-stage (1/256) frequency divider using a trigger flip-flop circuit in Fig. 1.

An embodiment of the present invention will be now described in detail, with reference to the accompanying drawings.

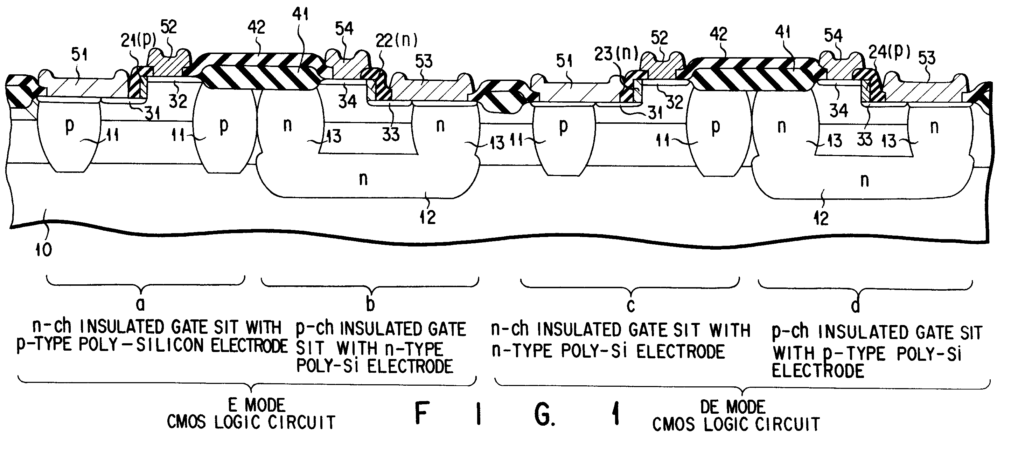

Fig. 1 shows a cross sectional view of the U-grooved insulated gate static induction transistors (SITs) which constitute the CMOS integrated circuits according to the embodiment of the present invention.

All of the U-grooved insulated gate SITs are formed on the high resistivity epitaxial layer on the major surface of the semiconductor substrate 10. U-shaped grooves are formed on the major surface of the semiconductor substrate. This gate oxide and poly-silicon gate electrodes 21 to 24 are formed at the side wall of the groove.

Each of the p-channel U-grooved insulated gate SITs is isolated by an n-type buried layer 12 and n-type channel stopper 13. Each of the n-channel U-grooved insulated gate SITs is isolated by a p-type channel stopper 11.

A source region 31 and a drain region 32 are formed in each of the n-channel insulated gate SITs, and a source region 33 and a drain region 34 are formed in each of the p-channel insulated gate SITs.

Furthermore, field oxide 41 and passivation oxide 42 are formed for device isolation and passivation. Metal wiring layers 51 to 54 are formed in their respective insulated gate SITs.

A gate electrode 21 of the p-channel insulated gate SIT (which is a region a) is formed by a p-type poly-silicon and a gate electrode 24 of the n-channel insulated gate SIT (which is a region b) is formed by n-type poly-silicon. In the case of these transistors, no drain current flows when a gate voltage equals zero. So, the CMOS circuit of this combination is called enhancement mode in which no power is dissipated in the steady state.

A gate electrode 22 of the p-channel insulated gate SIT (which is a region c) is formed by a p-type poly-silicon and a gate electrode 23 of the n-channel insulated gate SIT (which is a region d) is formed by n-type poly-silicon. In these transistors, small amount of drain current flows when a gate voltage equals zero. So, the CMOS circuit of this combination is called depletion-enhancement mode in which small power is dissipated in the steady state, but operates high speed.

Consequently, in the present invention, the depletion-enhancement mode CMOS logic circuit is used where the power dissipation in the transient state is larger than that of steady state.

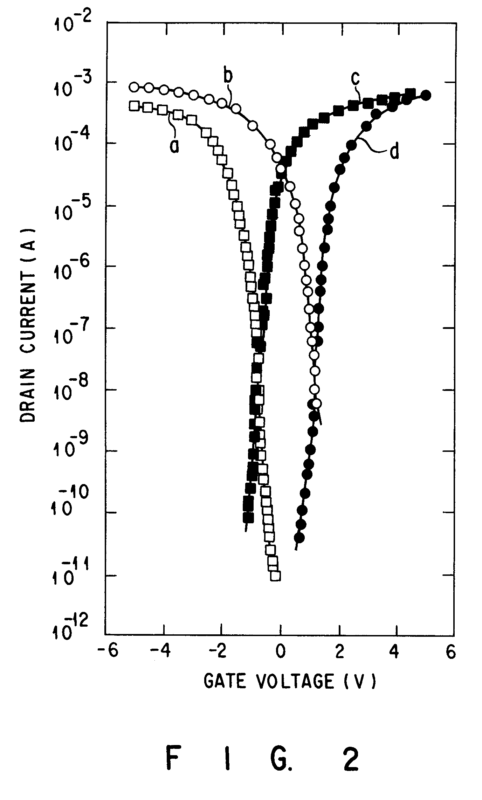

Fig. 2 shows a gate voltage - drain current characteristic of the U-grooved insulated gate static induction transistor according to the present invention. In Fig. 2, white plots a and b indicate the characteristics of p-channel MOS SITs and black plots c and d represent the characteristics of n-channel MOS SITs.

The plots a and c can be obtained if the gate electrodes are formed by n-type polysilicon of high impurity concentration, and the plots b and d can be obtained if they are formed by p-type polysilicon of high impurity concentration.

The CMOS logic circuit of the depletion enhancement mode is a combination of transistors having the characteristics represented by the plots b and c. In these transistors, drain current of about $2 \times 10^{-5}$ A flows when the gate voltage is 0. However, even though the supplied voltage is decreased to 1.5V, large drivability can be obtained because the current of about $5 \times 10^{-4}$ A can be caused to flow.

The COMS logic circuit of the enhancement mode is a combination of transistors having the characteristics indicated by the plots a and d. In these transistors drain current hardly flows when the gate voltage is 0. However, when the supplied voltage is decreased to 1.5V, the current of only $10^{-5}$ or less can be caused to flow, so large drivability cannot be expected.

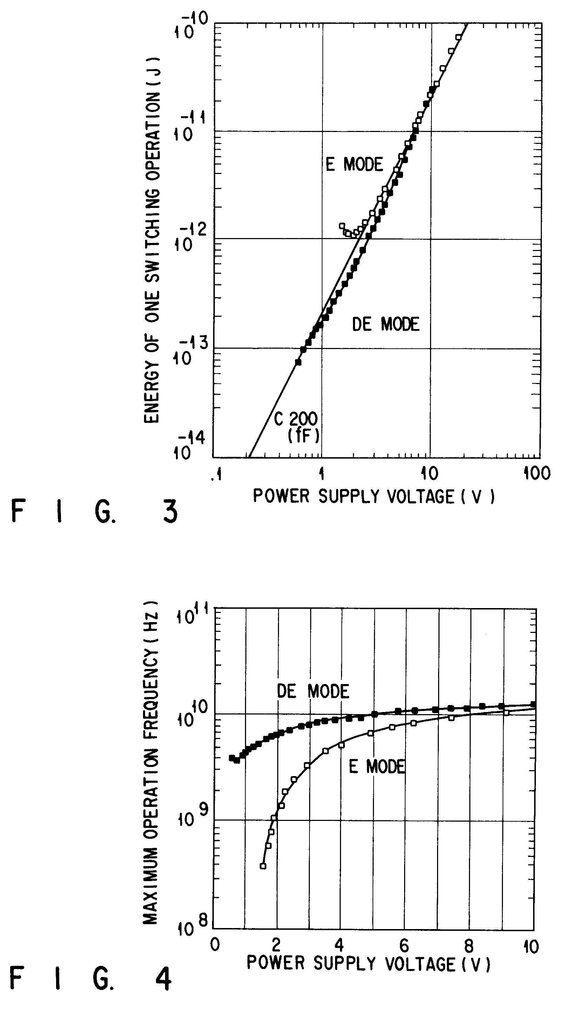

Fig. 3 shows a relationship between supplied voltage and energy loss in which the depletion enhancement mode CMOS logic circuit and the enhancement mode CMOS logic circuit are compared. Since the load capacitances of these CMOS logic circuits can be regarded as the same, there is no difference in the energy loss proportional to the square of the supplied voltage.

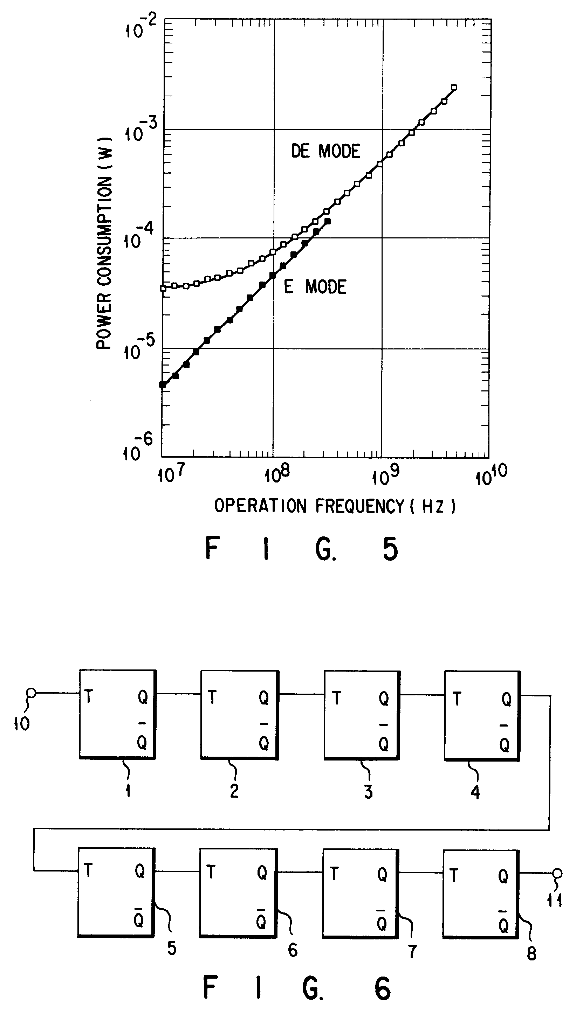

Fig. 4 shows a relationship between supplied voltage and maximum operation frequency in which the depletion enhancement mode CMOS logic circuit and the enhancement CMOS logic circuit are compared. It is apparent from Fig. 2 that the maximum operation frequency of the depletion enhancement mode CMOS logic circuit is higher than that of the enhancement mode, CMOS logic circuit, especially when the power supply voltage is low. For example, when the supplied voltage is 1.5V, the enhancement mode CMOS logic circuit operates up to about 350 MHz. In comparison, the depletion enhancement CMOS logic circuit up to about 5.5 GHz.

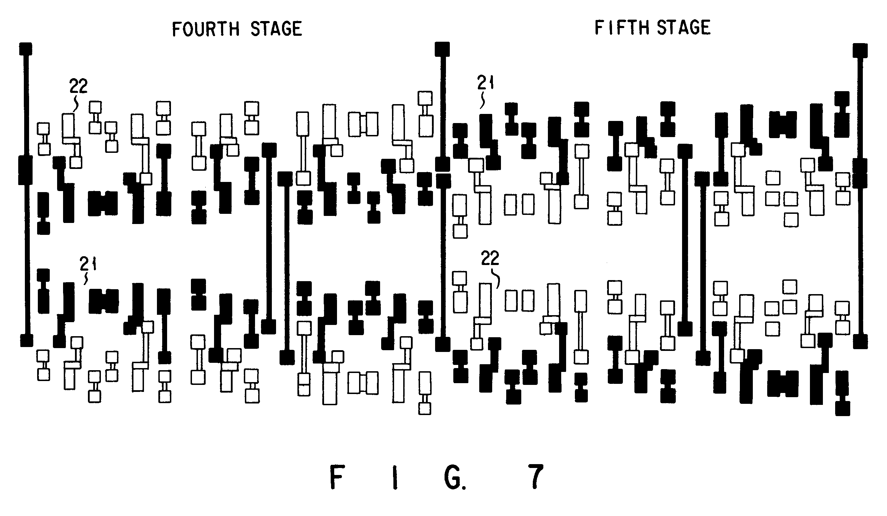

Fig. 5 shows a relationship between the operation frequency and power dissipation when the supplied voltage of the logic circuit is 1.5V in which the depletion enhancement mode CMOS logic circuit and the enhancement mode CMOS logic circuit are compared. Since power is dissipated in the steady state in the depletion enhancement mode CMOS logic circuit, the power dissipation is not decreased even if the operation frequency is lowered. In other words, it is significant to use the depletion enhancement mode CMOS logic circuit if power dissipation in the transient state exceeds power dissipation in the steady state. The CMOS logic circuit of the enhancement mode can be replaced with that of the depletion enhancement mode to operate in response to an input signal having a frequency incapable of operating the former CMOS logic circuit.

Fig. 6 shows a circuit diagram of an eight-stage (1/256) frequency divider using a trigger flip-flop circuit according to the present invention. In Fig. 6, trigger flip-flop circuits 1-4 are composed by the depletion enhancement mode CMOS logic circuit, and trigger flip-flop circuits 5-8 are composed by the enhancement mode CMOS logic circuits.

The frequency divider receives high-frequency input from a terminal 10 and produces a 1/256 frequency output from a terminal 11. Whenever high-frequency power having the maximum operation frequency is input from the terminal 10, the first stage trigger flip-flop circuit 1 repeats a switching operation at the maximum speed.

The second stage trigger flip-flop circuit 2 is operated at half of the frequency of the input signal and the fourth stage trigger flip-flop circuit 4 is also operated at one sixteenth of the frequency of the input signal. In the fourth stage trigger flip-flop circuit 4, power dissipation in the transient state is still higher than that in the steady state. In the fifth stage trigger flip-flop circuit 5, the operation frequency is enough low to use the enhancement mode CMOS logic circuit. It is therefore effective to use the depletion-enhancement mode CMOS logic circuit in the first to fourth stages of the 1/256 frequency divider and to use the enhancement mode CMOS logic circuit in the fifth to eighth stages of the 1/256 frequency divider.

To attain the same maximum operation frequency by the frequency divider formed only of the trigger flip-flop circuits of the enhancement mode CMOS logic circuit, as is apparent from Fig. 4, a supplied voltage of about 4V is required, and power dissipation in the switching operation at least seven times larger than the case of present invention.

If the frequency divider is formed of only trigger flip-flop circuits of the depletion enhancement mode CMOS logic circuit, the power dissipation in the steady state exceed the power dissipation in the transient state at the maximum operation frequency of enhancement mode CMOS logic circuit.

Fig. 7 shows mask patterns of polysilicon electrodes on the fourth and fifth stages of the 1/256 frequency divider of the present invention. In Fig. 7, black patterns 21 represent n-type polysilicon electrodes, and white patterns 22 represent p-type polysilicon electrodes. As is apparent from Fig. 7, in order to achieve the frequency divider of the present invention, the conductivity types of the gate electrode have only to be changed to each other between the fourth and fifth stages, and a new special manufacturing process need not be added.

As described above, the present invention provides a CMOS integrated circuit capable of high-speed and low power operation at low supplied voltage. The CMOS integrated circuit can be achieved without any special manufacturing process and it is industrially valuable.

## Claims

1. A U-grooved insulated gate static induction transistor integrated circuit comprising:

   an enhancement mode CMOS logic circuit (a, b) including a U-grooved insulated gate static induction transistor in which a threshold voltage is determined to prevent current from flowing in a steady state; and

   a depletion enhancement mode CMOS logic circuit (c, d) including a U-grooved insulated gate static induction transistor in which a threshold voltage is determined to cause current to slightly flow in the steady state,

   said enhancement mode CMOS logic circuit (a, b) and said depletion enhancement mode CMOS logic circuit (c, d) being formed on a major surface of a substrate (10), and said depletion enhancement mode CMOS logic circuit (c, d) being used in a circuit in which an average power dissipation in a transient state is higher than that in the steady state.

2. The integrated circuit according to claim 1, characterized in that said enhancement mode CMOS logic circuit (a, b) includes an n-channel U-grooved insulated gate static induction transistor having a polysilicon gate electrode (21) of p-type high impurity concentration and a p-channel U-grooved insulated gate static induction transistor having a polysilicon gate electrode (22) of n-type high impurity concentration, and said depletion enhancement mode CMOS logic circuit (c, d) includes an n-channel U-grooved insulated gate static induction transistor having a polysilicon gate electrode (23) of n-type high impurity concentration and a p-channel U-grooved insulated gate induction transistor having a polysilicon gate electrode (24) of p-type high impurity concentration.

3. The integrated circuit according to claim 1, characterized in that said enhancement mode CMOS logic circuit (a, b) is replaced with said depletion enhancement mode CMOS logic circuit (c, d) when an input signal has a frequency incapable of operating said enhancement mode CMOS logic circuit (a, b).

4. The frequency divider according to claim 1 or 2, characterized in that first to fourth stages trigger flip-flop circuits (1, 2, 3, 4) comprise depletion enhancement mode CMOS logic circuits and fifth to eighth stages trigger flip-flop circuits (5, 6, 7, 8) comprise enhancement mode CMOS logic circuits.

5. The frequency divider according to claim 4, characterized in that the mask patterns of the p-type gate electrode (21) and the mask patterns of the n-type gate electrode (22) are only exchanged between first to fourth stages and fifth to eighth stages.

a — n-ch INSULATED GATE SIT WITH p-TYPE POLY-SILICON ELECTRODE

b — p-ch INSULATED GATE SIT WITH n-TYPE POLY-Si ELECTRODE

c — n-ch INSULATED GATE SIT WITH n-TYPE POLY-Si ELECTRODE

d — p-ch INSULATED GATE SIT WITH p-TYPE POLY-Si ELECTRODE

E MODE CMOS LOGIC CIRCUIT

DE MODE CMOS LOGIC CIRCUIT

FIG. 1

EP 0 534 329 A2

F I G. 2

F I G. 3

F I G. 4

EP 0 534 329 A2

F I G. 5

F I G. 6

FOURTH STAGE    FIFTH STAGE

22    21

21    22

F I G. 7

EP 0 534 329 A2